# EUROPEAN PATENT APPLICATION

(11) **EP 4 730 929 A1**
(43) Date of publication of application: **22.04.2026**
(21) Application number: 24853312.7
(22) Date of filing: 29.05.2024
(51) Int. Cl.: H05K 5/02

(54) **MIDDLE FRAME AND PREPARATION METHOD THEREFOR, AND ELECTRONIC DEVICE**

(30) Priority: 15.08.2023 CN 202311030853
(71) Applicant: Huawei Technologies Co., Ltd., Shenzhen, Guangdong 518129 (CN)
(72) Inventor: HUANG, Lizhong, Shenzhen, Guangdong 518129 (CN); WANG, Rong, Shenzhen, Guangdong 518129 (CN)
(74) Representative: Goddar, Heinz J.
(86) International application number: PCT/CN2024/096174
(87) International publication number: WO 2025/035897

(57) **Abstract**

Embodiments of this application relate to the field of electronic devices, and provide a middle frame and a preparation method thereof, and an electronic device, to implement a reliable connection between a middle plate and an outer frame, improve an impact resistance capability of the middle frame, and ensure consistency of radio frequency performance of a frame antenna of the electronic device. The middle frame includes the middle plate, the outer frame, and a connecting piece. The middle plate includes a mounting hole. The outer frame is located on an outer side of the middle plate. The outer frame includes a main body part and an extension part that are connected to each other, and the extension part and the middle plate are stacked. The connecting piece is located in the mounting hole and is connected to the middle plate. The connecting piece is welded to the extension part. A material of the middle plate includes one of magnesium alloy, a magnesium matrix composite material, and aluminum alloy. A material of the outer frame includes one of aluminum alloy, a titanium-based material, an iron-based material, a titanium-aluminum composite material, and a steel-aluminum composite material. Microhardness of the connecting piece is greater than microhardness of the middle plate. The middle frame is used in the electronic device, to improve performance of the electronic device.

## Description

This application claims priority to Chinese Patent Application No. 202311030853.5, filed with the China National Intellectual Property Administration on August 15, 2023 and entitled "MIDDLE FRAME AND PREPARATION METHOD THEREOF, AND ELECTRONIC DEVICE", which is incorporated herein by reference in its entirety.

### TECHNICAL FIELD

This application relates to the field of electronic devices, and in particular, to a middle frame and a preparation method thereof, and an electronic device.

### BACKGROUND

A middle frame is one of important hardware components of an electronic device, and is configured to carry important components such as a main board and a battery of the electronic device. In addition, a display and a rear housing of the electronic device also need to be fastened to the middle frame. A structure of the middle frame greatly affects production costs and weight of the electronic device.

Currently, the middle frame generally includes a middle plate and an outer frame. A material of the middle plate includes magnesium alloy, a magnesium matrix composite material, or aluminum alloy, and a material of the outer frame includes aluminum, titanium, steel, or the like. The middle plate and the outer frame are connected in a welding manner. However, when the material of the middle plate includes the magnesium alloy or the magnesium matrix composite material, because the magnesium alloy or the magnesium matrix composite material has disadvantages such as a low melting point, a tendency to evaporate, high activity, and susceptibility to oxidation, when the middle plate and the outer frame are directly welded, a welding defect is prone to occurring at a welding joint between the middle plate and the outer frame. When the material of the middle plate includes the aluminum alloy, the middle plate is usually prepared by using a die casting process. However, a large quantity of air holes are prone to occur inside the middle plate prepared by using the die casting process. Consequently, when the middle plate and the outer frame are directly welded, the welding defect is also prone to occurring at the welding joint between the middle plate and the outer frame. The welding defect causes poor stability of the welding point, and consequently, an impact resistance capability of the middle frame is reduced.

In addition, with rapid development of communication technologies, an antenna used for communication is generally disposed on the electronic device, to implement functions such as calling and Internet access. The middle frame, as a good radiator, can be used as an antenna, and can effectively reduce space occupied by a built-in antenna in the electronic device. The welding defect between the middle plate and the outer frame also causes poor consistency of an impedance value of the welding point, affecting consistency of radio frequency performance of a frame antenna of the electronic device.

### SUMMARY

Embodiments of this application provide a middle frame and a preparation method thereof, and an electronic device, to implement a reliable connection between a middle plate and an outer frame, improve an impact resistance capability of the middle frame, and ensure consistency of radio frequency performance of a frame antenna of the electronic device.

To achieve the foregoing objectives, the following technical solutions are used in embodiments of this application.

According to a first aspect, a middle frame is provided, where the middle frame includes a middle plate, an outer frame, and a connecting piece. The middle plate includes a mounting hole. The outer frame is located on an outer side of the middle plate. The outer frame includes a main body part and an extension part that are connected to each other, the extension part is located on a side that is of the main body part and that faces the middle plate, and a thickness of the extension part is less than a thickness of the main body part. The extension part and the middle plate are stacked. The connecting piece is located in the mounting hole and is connected to the middle plate. The connecting piece is welded to the extension part. A material of the middle plate includes one of magnesium alloy, a magnesium matrix composite material, and aluminum alloy. A material of the outer frame includes one of aluminum alloy, a titanium-based material, an iron-based material, titanium-aluminum composite material, and a steel-aluminum composite material. Microhardness of the connecting piece is greater than microhardness of the middle plate.

In this embodiment of this application, the connecting piece is disposed in the mounting hole of the middle plate, so that the connecting piece is connected to the middle plate. The connecting piece is welded to the outer frame, so that the middle plate is fastened to the outer frame, to form the middle frame. When the material of the middle plate includes the magnesium alloy and/or the magnesium matrix composite material, because both a density of the magnesium alloy and a density of the magnesium matrix composite material are small, a weight of the middle plate may be small, and a weight of the middle frame may be small, thereby helping reduce a weight of an electronic device using the middle frame. When the material of the middle plate includes the aluminum alloy, the middle plate may be prepared by using a die casting process. In this way, in comparison with a manner of preparing the middle plate by using a computer numerical control machine tool, preparation costs of the middle plate may be low, and production efficiency of the middle plate may be high, thereby facilitating mechanical automatic production.

In this embodiment of this application, the material of the outer frame includes one of the aluminum alloy, the titanium-based material, the iron-based material, the titanium-aluminum composite material, and the steel-aluminum composite material, so that an appearance area of the middle frame may have a metal texture, thereby helping improve competitiveness of the electronic device using the middle frame.

In this embodiment of this application, the middle plate and the outer frame are connected by using the connecting piece, and the microhardness of the connecting piece is greater than the microhardness of the middle plate. This effectively resolves a problem that when the middle plate and the outer frame are directly welded, a welding defect occurs at a welding joint between the middle plate and the outer frame because the magnesium alloy or the magnesium matrix composite material has a low melting point, tends to evaporate, has high activity, and is susceptible to oxidation, or because there are a large quantity of air holes in a die casting aluminum material, so that reliability of a connection between the middle plate and the outer frame can be high. This helps improve stability of the middle frame and improve an impact resistance capability of the middle frame.

The middle frame is used as a good radiator, and therefore may be used as an antenna. In the middle frame provided in this embodiment of this application, the middle plate is connected to the connecting piece, and the outer frame is also welded to the connecting piece. A welding defect is not likely to occur at a connection position between the middle plate and the outer frame, thereby helping ensure consistency of an impedance value at the connection position between the middle plate and the outer frame, and further ensuring consistency of radio frequency performance of a frame antenna in the electronic device.

In addition, in the middle frame provided in this embodiment of this application, the outer frame and the connecting piece are connected by welding. In comparison with a case in which the middle plate and the outer frame are directly connected by using a rivet, stress at the connection position between the connecting piece and the outer frame may be small, and stress at the connection position between the middle plate and the outer frame may be small, so that the middle frame is not easily distorted and deformed, thereby effectively improving flatness of the middle frame. In comparison with a case in which the middle plate and the outer frame are connected in a rivet-free manner, a thickness of a connection position between the middle plate and the outer frame provided in this embodiment of this application may be small, to help reduce a thickness of the middle frame and reduce a thickness of the electronic device that uses the middle frame. An ultra-thin electronic device is implemented.

In some embodiments, the connecting piece includes a first connecting part and a second connecting part that are perpendicular to each other. The first connecting part is located in the mounting hole, and is welded to the extension part. A part of the middle plate is located between the second connecting part and the extension part.

In this way, the middle plate is limited between the second connecting part of the connecting piece and the extension part of the outer frame. In a thickness direction of the middle plate and a direction parallel to the middle plate, it is not easy to generate relative displacement between the middle plate and the connecting piece, and it is not easy to separate the middle plate from the connecting piece. In addition, both the first connecting part and the second connecting part of the connecting piece are in contact with the middle plate, and a contact area between the middle plate and the connecting piece may be further increased. A connection between the middle plate, the outer frame, and the connecting piece may be stable, thereby helping further improve a yield rate of the middle frame and improve use stability of the middle frame.

In some embodiments, the mounting hole is a stepped hole, and both the first connecting part and the second connecting part are located in the stepped hole. An end face that is of the second connecting part and that is away from the first connecting part is flush with a surface that is of the middle plate and that is away from the extension part.

In this case, the end face that is of the second connecting part and that is away from the first connecting part is flush with the surface that is of the middle plate and that is away from the extension part. In this way, flatness of the middle frame can be high, so that the middle frame can better carry an electronic component or a display, and the yield rate of the electronic device using the middle frame can be improved.

In some embodiments, the connecting piece is a cylinder, and the connecting piece is in interference fit with the mounting hole. In this way, a structure of the connecting piece is simple and easy to obtain. This helps simplify a structure of the middle frame.

In some embodiments, a material of the connecting piece is the same as a material of the outer frame. In this way, a melting point of the connecting piece may be the same as a melting point of the outer frame. When the connecting piece and the outer frame are welded, a yield rate of a welding point between the connecting piece and the outer frame is not easily affected due to a large difference between the melting point of the connecting piece and the melting point of the outer frame, thereby further improving connection strength between the connecting piece and the outer frame and improving the connection stability between the connecting piece and the outer frame.

In some embodiments, the mounting hole includes a through hole or a blind hole.

In some embodiments, the extension part includes a first part and a second part. The second part is disposed around the first part. The first part and the connecting piece have a molten pool. The molten pool extends from a surface that is of the first part and that is away from the middle plate to the connecting piece; or the molten pool extends from a surface that is of the connecting piece and that is away from the extension part to the first part.

In some embodiments, the main body part includes a first surface and a second surface that are opposite to each other, and a first side surface and a second side surface that are connected to the first surface and the second surface. The first surface is farther away from the extension part than the second surface, and the second surface is connected to the extension part. The middle frame further includes a decorative layer, and the decorative layer covers at least the first surface.

In this embodiment of this application, the decorative layer is disposed, so that a surface of the outer frame can be colored, appearance effect of the outer frame can be improved, and a user's preference for the electronic device can be increased. In addition, the decorative layer can be used to protect the outer frame, to avoid erosion of the outer frame by water vapor and oxygen in an environment.

In some embodiments, the molten pool extends from a surface that is of the first part and that is away from the middle plate to the connecting piece. The decorative layer further covers a surface that is of the second part and that is away from the middle plate, the first side surface, the second side surface, and a part that is of the second surface and that is not in contact with the extension part. When the molten pool extends from the surface that is of the first part and that is away from the middle plate to the connecting piece, the decorative layer exposes a surface that is of the first part and that is away from the connecting piece and a surface that is of the first part and that is close to the connecting piece. This helps avoid affecting a welding yield rate due to a high melting point of the decorative layer.

In some embodiments, the molten pool extends from the surface that is of the connecting piece and that is away from the extension part to the first part. The decorative layer further covers the surface that is of the first part and that is away from the middle plate, the surface that is of the second part and that is away from the middle plate, the first side surface, the second side surface, and the part that is of the second surface and that is not in contact with the extension part.

When the molten pool extends from the surface that is of the connecting piece and that is away from the extension part to the first part, the decorative layer exposes the surface that is of the first part and that is close to the connecting piece. This helps avoid affecting the welding yield rate due to the high melting point of the decorative layer.

In some embodiments, shear strength at a welding joint between the extension part and the connecting piece is greater than or equal to 100 N, and pulling strength at the welding joint between the extension part and the connecting piece is greater than or equal to 90 N. In this way, the extension part is stable in connection with the connecting piece, the outer frame is stable in connection with the middle plate and the connecting piece, the middle frame may be stable, and the middle frame may have a good impact resistance capability, thereby helping improve a service life of the electronic device.

In some embodiments, a material of the outer frame includes the titanium-aluminum composite material, the main body part includes a first sublayer and a second sublayer, the first sublayer is farther away from the extension part than the second sublayer, the second sublayer is connected to the extension part, a material of the first sublayer includes titanium, and materials of the second sublayer and the extension part both include aluminum alloy

In the outer frame provided in this embodiment of this application, the material of the first sublayer of the main body part is set to titanium metal, the material of the second sublayer is set to the aluminum alloy, and the material of the extension part is set to the aluminum alloy. A density of the aluminum alloy is less than a density of the titanium metal, so that the middle frame can have a small weight while having a metal texture and appearance effect, thereby helping reduce preparation costs of the middle frame.

Alternatively, a material of the outer frame includes the steel-aluminum composite material, the main body part includes a third sublayer and a fourth sublayer, the third sublayer is farther away from the extension part than the fourth sublayer, the fourth sublayer is connected to the extension part, a material of the third sublayer includes stainless steel, and materials of the fourth sublayer and the extension part both include aluminum alloy.

In the outer frame provided in this embodiment of this application, the material of the first sublayer of the main body part is set to stainless steel, the material of the second sublayer is set to aluminum alloy, and the material of the extension part is set to aluminum alloy. A density of the aluminum alloy is less than a density of the stainless steel, so that the middle frame can have a small weight while having a metal texture and appearance effect, thereby helping reduce preparation costs of the middle frame.

According to a second aspect, a middle frame preparation method is provided. The preparation method includes: providing a middle plate, an outer frame, and a connecting piece. The outer frame includes a main body part and an extension part that are connected to each other, and a thickness of the extension part is less than a thickness of the main body part. The connecting piece is mounted on the middle plate, where the connecting piece is located in a mounting hole of the middle plate. The middle plate is fastened to the outer frame. The outer frame is located on an outer side of the middle plate, the extension part is located on a side that is of the main body part and that faces the middle plate, and the extension part and the middle plate are stacked. The extension part is welded to the connecting piece. A material of the middle plate includes one of magnesium alloy, a magnesium matrix composite material, and aluminum alloy. A material of the outer frame includes one of aluminum alloy, a titanium-based material, an iron-based material, titanium-aluminum composite material, and a steel-aluminum composite material. Microhardness of the connecting piece is greater than microhardness of the middle plate.

In some embodiments, welding the extension part to the connecting piece includes: welding the extension part to the connecting piece by using a laser welding process.

In this embodiment of this application, the extension part and the connecting piece are welded by using a laser welding process, so that welding precision may be high, a deformation amount of the extension part and the connecting piece may be small, and stress between the extension part and the connecting piece may be small. After the extension part and the connecting piece are welded, the middle frame is not easily deformed, thereby helping improve flatness of the middle frame. In addition, laser welding has a high welding speed. The extension part and the connecting piece are welded by using the laser welding process, which is conducive to improving a preparation speed of the middle frame and improving preparation efficiency of the middle frame.

In some embodiments, the material of the outer frame includes aluminum alloy, and the preparation method further includes: forming a decorative layer by using an anodic oxidation process. Alternatively, the material of the outer frame includes one of a titanium-based material, an iron-based material, a titanium-aluminum composite material, and a steel-aluminum composite material, and the preparation method further includes: forming a decorative layer by using a physical vapor deposition process.

The main body part includes a first surface and a second surface that are opposite to each other, and a first side surface and a second side surface that are connected to the first surface and the second surface. The first surface is farther away from the middle plate than the second surface, and the second surface is connected to the extension part. The decorative layer covers at least the first surface.

According to a third aspect, an electronic device is provided. The electronic device includes a display, a rear housing, and the middle frame according to any one of the foregoing embodiments, where the middle frame is located between the display and the rear housing, and an outer frame of the middle frame is used as a side edge of the electronic device.

For technical effect brought by any design manner in the second aspect and the third aspect, refer to technical effect brought by different design manners in the first aspect. Details are not described herein again.

### BRIEF DESCRIPTION OF DRAWINGS

To describe technical solutions in this application more clearly, the following briefly describes accompanying drawings for describing some embodiments of this application. It is apparent that the accompanying drawings in the following descriptions are merely accompanying drawings in some embodiments of this application, and a person of ordinary skill in the art may still derive other drawings from these accompanying drawings. In addition, the accompanying drawings in the following descriptions may be considered as illustrative diagrams, and are not intended to limit an actual size of a product, an actual procedure of a method, an actual time sequence of a signal, and the like in embodiments of this application.
FIG. 1 is a diagram of a structure of an electronic device according to an embodiment of this application;
FIG. 2 is a diagram of a structure of a middle frame according to an embodiment of this application;
FIG. 3 is a top view of a middle frame according to an embodiment of this application;
FIG. 4 is an enlarged diagram of a middle frame shown in FIG. 3 at AA;
FIG. 5 is a sectional view of a middle frame shown in FIG. 3 at B-B';
FIG. 6A is another sectional view of a middle frame shown in FIG. 3 at B-B';
FIG. 6B is still another sectional view of a middle frame shown in FIG. 3 at B-B';
FIG. 6C is yet another sectional view of a middle frame shown in FIG. 3 at B-B';
FIG. 7A is still yet another sectional view of a middle frame shown in FIG. 3 at B-B';
FIG. 7B is further another sectional view of a middle frame shown in FIG. 3 at B-B';
FIG. 8 is further another sectional view of a middle frame shown in FIG. 3 at B-B';
FIG. 9A is further another sectional view of a middle frame shown in FIG. 3 at B-B';
FIG. 9B is further another sectional view of a middle frame shown in FIG. 3 at B-B';
FIG. 10 is a diagram of a physical object at a connection position between a connecting piece and an extension part according to an embodiment of this application;
FIG. 11 is a diagram of element detection at a connection position between a connecting piece and an extension part according to an embodiment of this application;
FIG. 12 is another diagram of a physical object at a connection position between a connecting piece and an extension part according to an embodiment of this application;
FIG. 13 is further another sectional view of a middle frame shown in FIG. 3 at B-B';
FIG. 14 is further another sectional view of a middle frame shown in FIG. 3 at B-B';
FIG. 15 is a flowchart of a middle frame preparation method according to an embodiment of this application;
FIG. 16 is a flowchart of another middle frame preparation method according to an embodiment of this application;
FIG. 17 is a state diagram corresponding to step S410 in a flowchart shown in FIG. 16;
FIG. 18 is another state diagram corresponding to step S410 in a flowchart shown in FIG. 16;
FIG. 19 is a flowchart of still another middle frame preparation method according to an embodiment of this application; and
FIG. 20 is a flowchart of yet another middle frame preparation method according to an embodiment of this application.

### DESCRIPTION OF EMBODIMENTS

The following describes the technical solutions in embodiments of this application with reference to the accompanying drawings in embodiments of this application. In descriptions of this application, unless otherwise specified, "/" indicates an "or" relationship between associated objects. For example, A/B may indicate A or B.

"And/or" in this application describes only an association relationship between associated objects and indicates that three relationships may exist. For example, A and/or B may indicate the following three cases: Only A exists, both A and B exist, and only B exists. A and B may be singular or plural.

In addition, in the descriptions of this application, "a plurality of" means two or more unless otherwise specified. At least one of the following items (pieces) or a similar expression thereof indicates any combination of these items, including a single item (piece) or any combination of a plurality of items (pieces). For example, at least one (piece) of a, b, or c may represent: a, b, c, a-b, a-c, b-c, or a-b-c, where a, b, and c may be singular or plural.

To clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

Embodiments of this application provide an electronic device. The electronic device is, for example, a consumer electronic product, a household electronic product, a vehicle-mounted electronic product, a financial terminal product, or a communication electronic product. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, an intelligent wearable product (for example, a smartwatch or a smart band), a virtual reality (virtual reality, VR) electronic device, an augmented reality (augmented reality, AR) electronic device, or an uncrewed aerial vehicle. The household electronic product is, for example, a smart door lock, a television, a remote control, a refrigerator, a small household charging appliance (for example, a soy milk maker or a robot vacuum), or the like. The vehicle-mounted electronic product is, for example, a vehicle-mounted navigator or a vehicle-mounted high-density digital video disc (digital video disc, DVD). The financial terminal product is, for example, an automated teller machine (automated teller machine, ATM) or a terminal for self-help service handling. A specific form of the electronic device is not specifically limited in embodiments of this application.

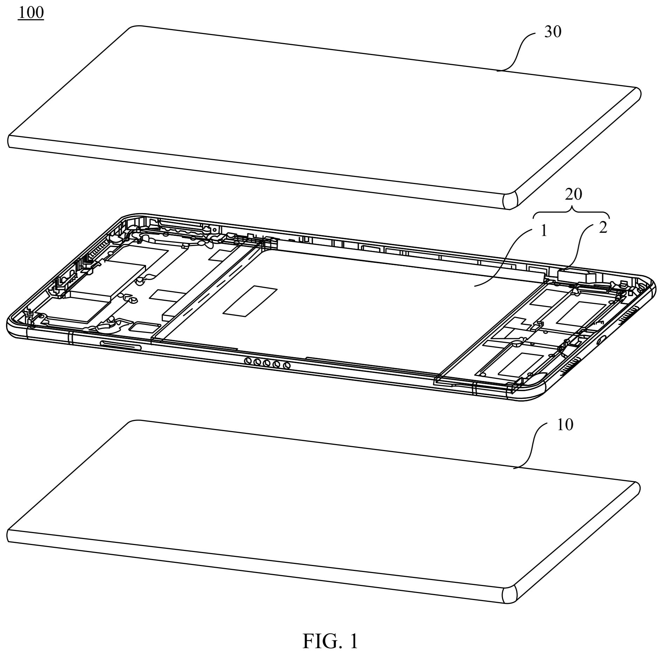

For ease of description, an example in which the electronic device is a tablet computer is used below for description. As shown in FIG. 1, an electronic device 100 mainly includes a display 10, a middle frame 20, and a rear housing 30. The middle frame 20 is located between the display 10 and the rear housing 30. A display surface of the display 10 is away from the middle frame 20.

For example, the display 10 may be a liquid crystal display (liquid crystal display, LCD). In this case, the liquid crystal display includes a liquid crystal display panel and a backlight module. The liquid crystal display panel is disposed on a side that is of the backlight module and that is away from the middle frame, and the backlight module is configured to provide a light source for the liquid crystal display panel.

Alternatively, the display 10 may be an organic light emitting diode (organic light emitting diode, OLED) display. Because the OLED display is a self-luminous display, no backlight module needs to be disposed. In this case, the display 10 may alternatively be a flexible screen having bending performance, that is, a folded screen, or may be a rigid display.

The electronic device 100 may further include electronic components such as a printed circuit board (printed circuit board, PCB), a battery, and a camera. The electronic components such as the printed circuit board, the battery, and the camera may be disposed on the middle frame 20. For example, the electronic components such as the printed circuit board (mainboard), the battery, and the camera may be located on a side that is of the middle frame 20 and that is away from the display 10.

As an important component of the electronic device 100, the printed circuit board may be mounted with various components that form a circuit system of the electronic device, for example, a circuit, a processor, a chip, a capacitor, a resistor, an inductor, a structure, and a plug-in. Optionally, the printed circuit board may be provided with an integrated circuit chip, a power management unit chip, a radio frequency chip, or the like. In addition, various processors such as a central processing unit, various application processors, a graphics processing unit, an image signal processor, or the like are usually disposed on the printed circuit board. This is not limited thereto.

As an energy storage tool of the electronic device 100, the battery may be a lithium battery, a nickel metal battery, a sodium-ion battery, or the like.

The camera may include components such as a front-facing camera, a rear-facing camera, and a flash.

The rear housing 30 may protect electronic components in the electronic device 100, to prevent water vapor and/or dust from affecting normal operation of the electronic components. In addition, the rear housing 30 can also ensure neatness of an appearance of the electronic device. A material of the rear housing 30 is not limited in this embodiment of this application. For example, the material of the rear housing 30 may be a conductive material such as metal. For another example, the material of the rear housing 30 may be a non-conductive material such as glass or plastic. When the material of the rear housing 30 is a conductive material, the rear housing 30 may be used as a reference ground of an electronic component or a radio frequency component in the electronic device 300.

In some examples, the electronic device 100 may further include a cover, and the cover is disposed on a side that is of the display 10 and that is away from the middle frame 20, and is configured to protect the display 10.

When the electronic device 100 is a mobile phone, the electronic device 100 may be a foldable mobile phone or a bar mobile phone. This is not limited in this application.

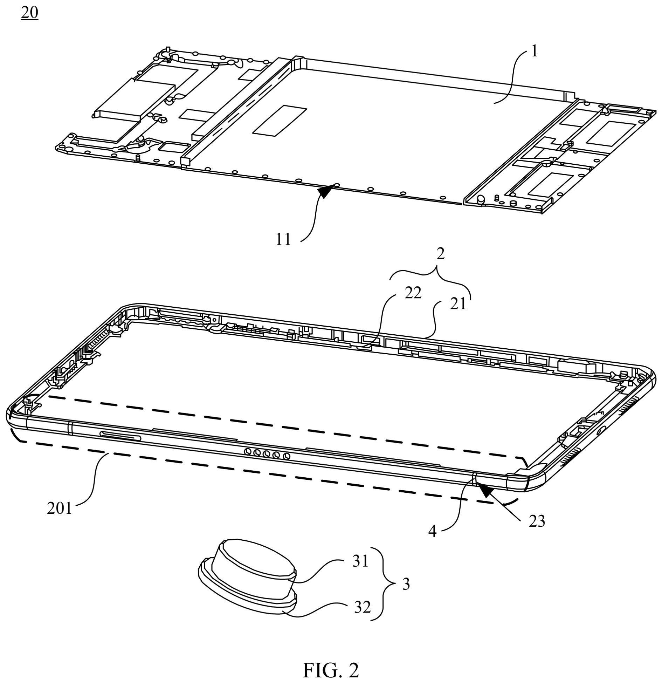

The following describes in detail the middle frame 20 provided in embodiments of this application with reference to FIG. 2 to FIG. 14.

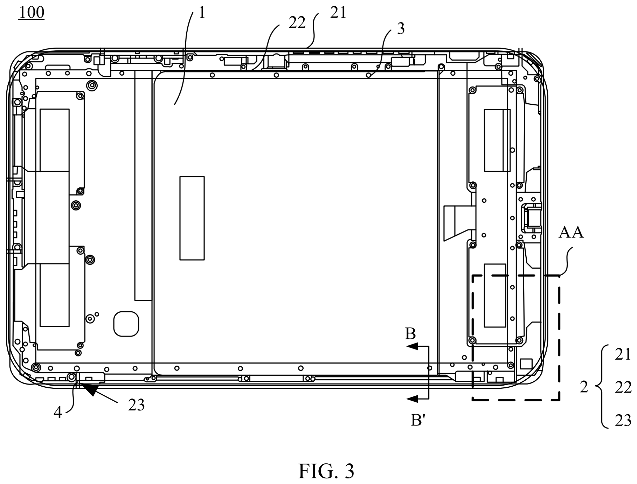

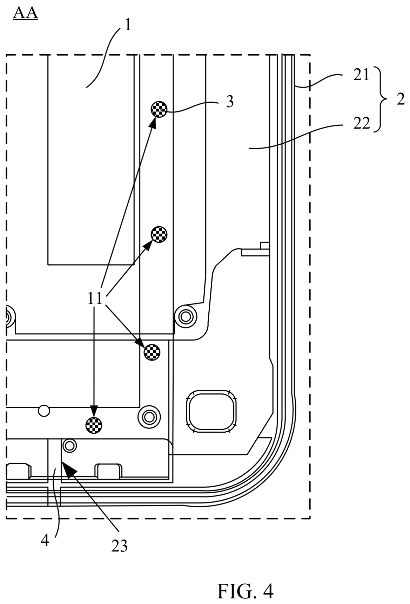

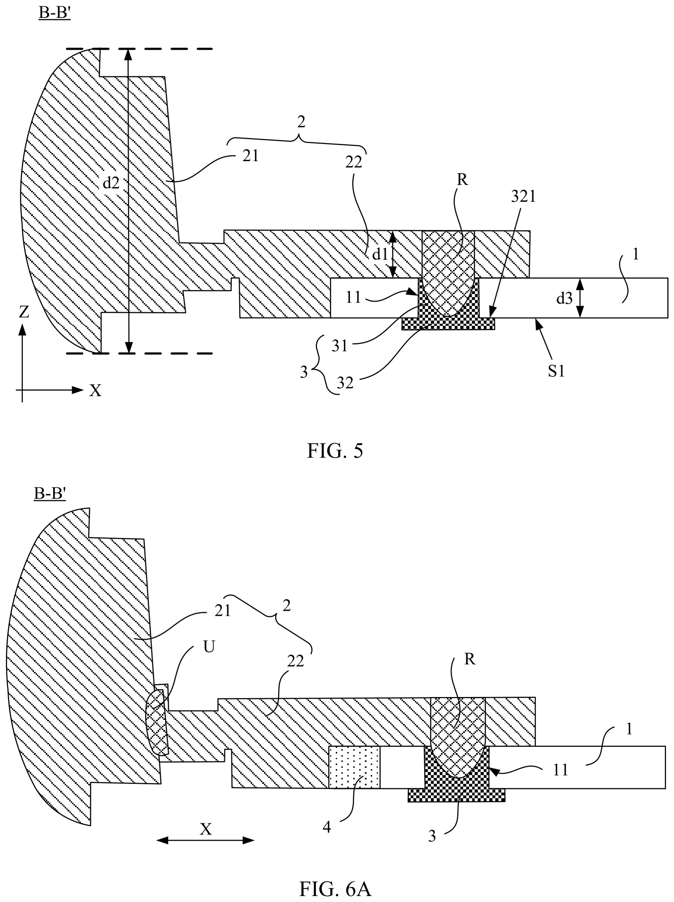

FIG. 2 is an exploded diagram of the middle frame 20 according to an embodiment of this application. FIG. 3 is a top view of the middle frame 20 according to an embodiment of this application. FIG. 4 is an enlarged diagram of a structure of the middle frame 20 shown in FIG. 3 at AA. FIG. 5 is a sectional view of the middle frame 20 shown in FIG. 3 at B-B'. FIG. 6A is another sectional view of the middle frame 20 shown in FIG. 3 at B-B'. Refer to FIG. 2 to FIG. 6A. An embodiment of this application provides the middle frame 20. As shown in FIG. 2, the middle frame 20 includes a middle plate 1, an outer frame 2, and a connecting piece 3.

The middle plate 1 includes a mounting hole 11. For example, the middle plate 1 may include a plurality of mounting holes 11, and the plurality of mounting holes 11 are distributed at an edge of the middle plate 1.

When the middle plate 1 includes the plurality of mounting holes 11, sizes of the plurality of mounting holes 11 may be the same or may be different. Herein, that "the sizes of the plurality of mounting holes 11 are different" means that there is at least one mounting hole 11 that is in the plurality of mounting holes 11 and whose size is different from sizes of other mounting holes 11. In this embodiment of this application, neither a specific quantity of mounting holes 11 in the middle plate 1 nor specific sizes of the mounting holes 11 is limited, and may be designed based on an actual requirement.

In this embodiment of this application, a distribution position of the mounting hole 11 is not limited either. A specific distribution position of the mounting hole 11 may be designed based on a structure of the middle plate 1 and a structure of the outer frame 2, so that the middle plate 1 is stably connected to the outer frame 2. For example, as shown in FIG. 4, a distribution density of the mounting holes 11 may be large at a corner of the middle plate 1, and a distribution density of the mounting holes 11 may be small on a side edge of the middle plate 1.

A material of the middle plate 1 may include one of magnesium alloy, a magnesium matrix composite material, and aluminum alloy. For example, the magnesium alloy may be AZ91D, AM60, AZ31, AZ80, AZ91D, ZK61, or the like.

As shown in FIG. 3, the outer frame 2 is located on an outer side of the middle plate 1. Refer to FIG. 2 and FIG. 3. The outer frame 2 may be used as a side edge of the electronic device 100.

Refer to FIG. 5. The outer frame 2 includes a main body part 21 and an extension part 22 that are connected to each other, the extension part 22 is located on a side that is of the main body part 21 and that faces the middle plate 1, and a thickness d1 of the extension part 22 is less than a thickness d2 of the main body part 21. The extension part 22 and the middle plate 1 are stacked. Specific values of the thickness d1 of the extension part 22 and the thickness d2 of the main body part 21 are not limited in this embodiment of this application, and may be designed based on an actual requirement.

In some examples, as shown in FIG. 5, a sum of a thickness d3 of a part that is of the middle plate 1 and that is in contact with the extension part 22 and the thickness d1 of the extension part is less than the thickness d2 of the main body part 21 of the outer frame 2. In this way, the sum of the thickness d3 of the part that is of the middle plate 1 and that is in contact with the extension part 22 and the thickness d1 of the extension part may be small, thereby helping reduce the thickness of the middle frame 20. In addition, the sum of the thickness d3 of the part that is of the middle plate 1 and that is in contact with the extension part 22 and the thickness d1 of the extension part may be small, and an electronic component may be further disposed at a position at which the middle plate 1 and the extension part 22 are stacked, thereby improving space utilization at the position at which the middle plate 1 and the extension part 22 are stacked.

In some examples, as shown in FIG. 5, the main body part 21 and the extension part 22 may be of an integrated structure. In this case, the main body part 21 and the extension part 22 are not easily separated, and connection stability of the main body part 21 and the extension part 22 may be high, thereby helping improve structural stability of the outer frame 2, and further improving structural stability of the middle frame 20.

In some other examples, as shown in FIG. 6A, the main body part 21 and the extension part 22 may be connected in a welding manner. In this way, the main body part 21 and the extension part 22 provided in this embodiment of this application may be separately prepared, and sizes of raw materials used in preparation processes of the main body part 21 and the extension part 22 may be small, thereby helping reduce preparation costs of the outer frame 2, and further reducing preparation costs of the middle frame 20.

In this case, as shown in FIG. 6A, a molten pool U may exist in a part that is in the main body part 21 and that is in contact with the extension part 22, and a part that is in the extension part 22 and that is in contact with the main body part 21.

For example, the main body part 21 and the extension part 22 may be welded in a spot welding manner or a seam welding manner.

In some examples, as shown in FIG. 2, the outer frame 2 may include a plurality of frame bars 201. For example, the outer frame 2 may include two frame bars 201, and the two frame bars 201 may be respectively located on two opposite sides of the middle plate 1. Alternatively, the outer frame 2 may include three frame bars, and the three frame bars are connected head to tail to form a U-shaped structure. In this case, the middle frame 20 may be used in a foldable electronic device. Alternatively, the outer frame 2 may include four frame bars 201, and the four frame bars 201 are sequentially connected head to tail to form an enclosed structure. In this case, the outer frame 2 may be disposed around the middle plate 1. Each frame bar 201 may include the main body part 21 and the extension part 22.

A material of the outer frame 2 may include one of aluminum alloy, a titanium-based material, an iron-based material, a titanium-aluminum composite material, and a steel-aluminum composite material. For example, the aluminum alloy may include five-series aluminum alloy, six-series aluminum alloy, seven-series aluminum alloy, or the like. The titanium-based material may include, for example, titanium and titanium alloy. The iron-based material may include, for example, stainless steel.

In some examples, the stainless steel (Stainless Steel) is stainless steel defined in GB/T20878-2007. Chromium content of the stainless steel is at least 10.5%, and maximum carbon content of the stainless steel does not exceed 1.2%. In an embodiment in which the material of the outer frame 2 is the stainless steel, a model of the stainless steel is not limited, and the model of the stainless steel may be, for example, SUS316L. The stainless steel has advantages of a high elastic modulus and high strength. The outer frame 2 made of the stainless steel material can provide excellent support performance for a structure (for example, a display or a cover) of the electronic device 100, and provide a basis for a light and thin outer frame 2 with excellent strength.

In an embodiment in which the material of the outer frame 2 is titanium alloy, a model of the titanium alloy is not limited. For example, the model of the titanium alloy may be TC4. Similarly, the titanium alloy also has advantages of a high elastic modulus and high strength, and the outer frame 2 made of the titanium alloy material can have advantages of being light, thin, and highly strong.

The connecting piece 3 is located in the mounting hole 11, and is connected to the middle plate 1. The connecting piece 3 is welded to the extension part 22. Microhardness of the connecting piece 3 is greater than microhardness of the middle plate 1. For example, a material of the connecting piece 3 may include one of an aluminum-based material, a titanium-based material, an iron-based material, a copper-based material, a nickel-based material, and a zirconium-based material. It may be understood that the connecting piece 3 is located in the mounting hole 11, and a quantity of connecting pieces 3 should be the same as a quantity of mounting holes 11.

In this embodiment of this application, the connecting piece 3 is disposed in the mounting hole 11 of the middle plate 1, so that the connecting piece 3 is connected to the middle plate 1; and the connecting piece 3 is welded to the outer frame 2, so that the middle plate 1 is fastened to the outer frame 2, to form the middle frame 20. When the material of the middle plate 1 includes the magnesium alloy and/or the magnesium matrix composite material, because a density of the magnesium alloy and a density of the magnesium matrix composite material are small, a weight of the middle plate 1 may be small, and a weight of the middle frame 20 may be small, thereby helping reduce a weight of the electronic device 100 using the middle frame 20. When the material of the middle plate 1 includes the aluminum alloy, the middle plate 1 may be prepared by using a die casting process. In this way, in comparison with a manner of preparing the middle plate by using a computer numerical control machine tool (Computer numerical control machine tool, CNC), preparation costs of the middle plate 1 may be low, and production efficiency of the middle plate 1 may be high, thereby facilitating mechanical automatic production.

In this embodiment of this application, the material of the outer frame 2 includes one of the aluminum alloy, the titanium-based material, the iron-based material, the titanium-aluminum composite material, and the steel-aluminum composite material, so that an appearance area of the middle frame 20 may have a metal texture, thereby helping improve competitiveness of the electronic device 100 using the middle frame 20.

In this embodiment of this application, the middle plate 1 and the outer frame 2 are connected by using the connecting piece 3, and the microhardness of the connecting piece 3 is greater than the microhardness of the middle plate 1. This effectively resolves a problem that when the middle plate and the outer frame are directly welded, a welding defect occurs at a welding joint between the middle plate and the outer frame because the magnesium alloy or the magnesium matrix composite material has a low melting point, tends to evaporate, has high activity, and is susceptible to oxidation, or because there are a large quantity of air holes in a die casting aluminum material, so that reliability of a connection between the middle plate 1 and the outer frame 2 can be high. This helps improve stability of the middle frame 20 and improve an impact resistance capability of the middle frame 20.

The middle frame 20 is used as a good radiator, and therefore may be used as an antenna. In the middle frame 20 provided in this embodiment of this application, the middle plate 1 is connected to the connecting piece 3, and the outer frame 2 is also welded to the connecting piece 3. A welding defect is not likely to occur at a connection position between the middle plate 1 and the outer frame 2, thereby helping ensure consistency of an impedance value at the connection position between the middle plate 1 and the outer frame 2, and further ensuring consistency of radio frequency performance of a frame antenna in the electronic device 100.

In this embodiment of this application, an impedance value at a location of the connecting piece 3 in the middle frame 20 is tested. A test device is a resistance tester, and a test result is shown in Table 1. It can be learned from Table 1 that, at the location of the connecting piece 3, impedance measured at each test point is small, and a difference between impedance measured at different test points is also small. Therefore, good metal conduction can be implemented between the middle plate 1 and the outer frame 2 of the middle frame 20. In this way, when the middle frame 20 is used as the antenna, the middle frame 20 can operate not only in a low frequency band such as 2.4 GHz, but also in a high frequency band such as 5 GHz. In particular, when the middle frame 20 is used as an antenna in a 4 GHz frequency band or 5 GHz frequency band with a frequency greater than 2 GHz, a Wi-Fi antenna, or the like, resistance at the location of the connecting piece 3 in this embodiment of this application is small, so that a loss of radio frequency operation is low. An impedance fluctuation range at the location of the connecting piece 3 is small (in other words, an impedance difference between different locations is small), and a frequency offset of the radio frequency operation can be further reduced.

**Table 1**

| Test point | Impedance (Ω) |
|---|---|
| Test point 1 | 0.04 |
| Test point 2 | 0.07 |
| Test point 3 | 0.03 |
| Test point 4 | 0.03 |
| Test point 5 | 0.06 |
| Test point 6 | 0.07 |
| Test point 7 | 0.01 |
| Test point 8 | 0.02 |
| Test point 9 | 0.02 |
| Test point 10 | 0.02 |

In addition, in the middle frame 20 provided in this embodiment of this application, the outer frame 2 and the connecting piece 3 are connected by welding. In comparison with a case in which the middle plate and the outer frame are directly connected by using a rivet, stress at the connection position between the connecting piece 3 and the outer frame 2 may be small, and stress at the connection position between the middle plate 1 and the outer frame 2 may be small, so that the middle frame 20 is not easily distorted and deformed, thereby effectively improving flatness of the middle frame 20. In comparison with a case in which the middle plate and the outer frame are connected in a rivet-free manner, a thickness of a connection position between the middle plate 1 and the outer frame 2 provided in this embodiment of this application may be small, to help reduce a thickness of the middle frame 20 and reduce a thickness of the electronic device 100 that uses the middle frame 20. An ultra-thin electronic device 100 is implemented.

In some embodiments, refer to FIG. 2 to FIG. 4. The outer frame 2 may further include an antenna slot 23, and the middle frame 20 may further include a filling part 4. The filling part 4 is located in the antenna slot 23, and a material of the filling part 4 is an insulating material. The antenna slot 23 may divide the outer frame 2 into a plurality of parts, and the filling part 4 is located in the antenna slot 23 to insulate two adjacent parts. The plurality of parts may be used as different antennas respectively.

The "different antennas" mentioned herein may be, for example, a main antenna, a Wi-Fi antenna, or a Bluetooth antenna. A type of the antenna is not specifically limited in this embodiment of this application.

For example, a material of the filling part 4 may be a thermosetting or thermoplastic material, for example, plastic or resin.

When the plurality of parts of the outer frame 2 are used as an antenna, the outer frame 2 includes a plurality of feed points. The feed points are electrically connected to the middle plate 1, and a position of the outer frame 2 other than the feed points is insulated from the middle plate 1. In this embodiment of this application, a quantity of feed points in the outer frame 2 and a location of the feed point are not limited, provided that the antenna can be electrically connected to the middle plate 1.

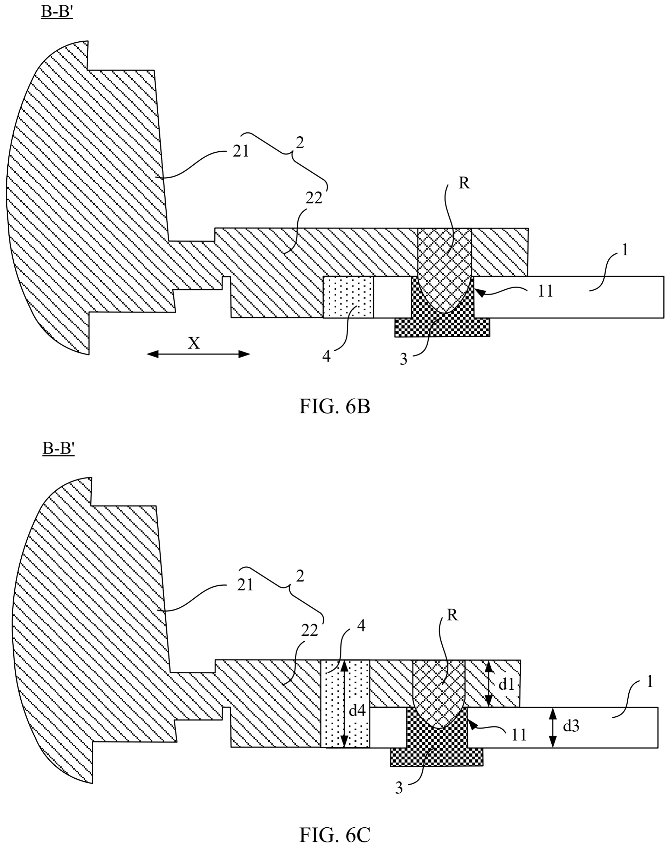

FIG. 5, FIG. 6A, and FIG. 6B may be three possible sectional views of a connection position between a feed point in the outer frame 2 and the middle plate 1. As shown in FIG. 5, the filling part 4 may not extend to a position between the feed point and the middle plate 1. Alternatively, as shown in FIG. 6A and FIG. 6B, in a direction X parallel to the middle plate 1, the filling part 4 may further extend to a position between the extension part 22 and the middle plate 1, but the filling part 4 does not affect signal transmission between the feed point and the middle plate 1.

At a position of the outer frame 2 other than the feed point, as shown in FIG. 6C, the filling part 4 may extend to the extension part 22 of the outer frame 2. A sum of a thickness d3 of a part that is of the middle plate 1 and that is in contact with the extension part 22 and a thickness d1 of the extension part 22 is less than or equal to a thickness d4 of the filling part 4. The filling part 4 is configured to separate a part that is in the extension part 22 and that is connected to the main body part 21 from a part that is in the extension part 22 and that is connected to the middle plate 1, so that the outer frame 2 is insulated from the middle plate 1.

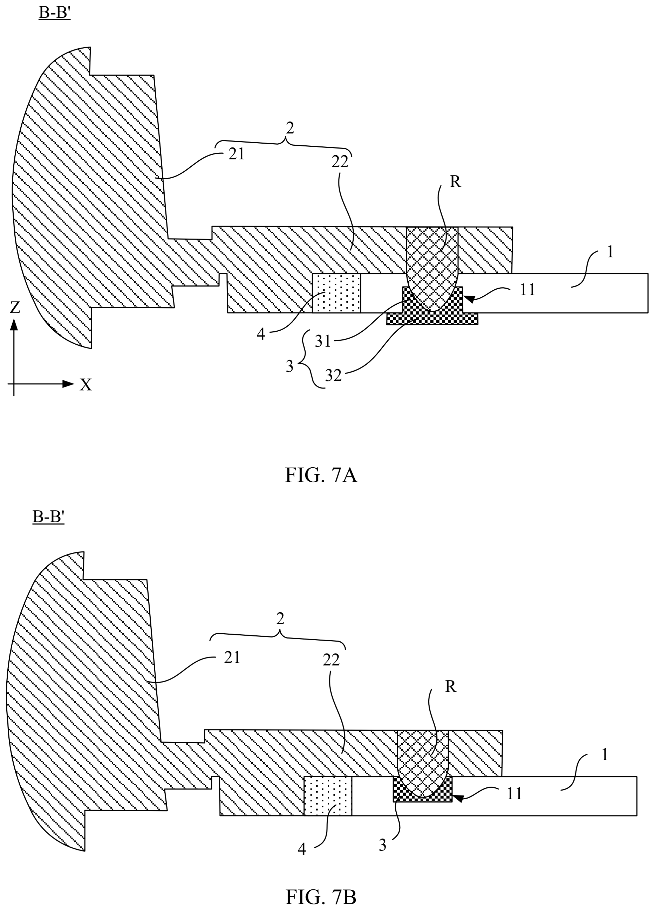

In some embodiments, as shown in FIG. 6C, the mounting hole 11 may be a through hole. In some other embodiments, as shown in FIG. 7A and FIG. 7B, the mounting hole 11 may be a blind hole.

When the middle plate 1 includes a plurality of mounting holes 11, the plurality of mounting holes 11 may all be through holes. Alternatively, the plurality of mounting holes 11 may all be blind holes. Alternatively, some of the plurality of mounting holes 11 are through holes, and the other part of the plurality of mounting holes 11 are blind holes.

When the mounting hole 11 is the blind hole, as shown in FIG. 7A, the mounting hole 11 may be located on a side that is of the middle plate 1 and that is away from the extension part 22. Alternatively, as shown in FIG. 7B, the mounting hole 11 may also be located on a side that is of the middle plate 1 and that is close to the extension part 22.

In some embodiments, a material of the connecting piece 3 may be the same as a material of the outer frame 2. In this way, a melting point of the connecting piece 3 may be the same as a melting point of the outer frame 2. When the connecting piece 3 and the outer frame 2 are welded, a yield rate of a welding point between the connecting piece and the outer frame 2 is not easily affected due to a large difference between the melting point of the connecting piece 3 and the melting point of the outer frame 2, thereby further improving connection strength between the connecting piece 3 and the outer frame 2 and improving the connection stability between the connecting piece 3 and the outer frame 2.

In some examples, shear strength at a welding joint between the extension part 22 and the connecting piece 3 is greater than or equal to 100 N, and pulling strength at the welding joint between the extension part 22 and the connecting piece 3 is greater than or equal to 90 N. In this way, the extension part 22 is stable in connection with the connecting piece 3, the outer frame 2 is stable in connection with the middle plate 1 and the connecting piece 3, the middle frame 20 may be stable, and the middle frame 20 may have a good impact resistance capability, thereby helping improve a service life of the electronic device 100.

Refer to FIG. 2, FIG. 5, and FIG. 7A. In some embodiments, the connecting piece 3 may include a first connecting part 31 and a second connecting part 32 that are perpendicular to each other, the first connecting part 31 is located in the mounting hole 11, and is welded to the extension part 22, and a part of the middle plate 1 is located between the second connecting part 32 and the extension part 22.

In this way, the middle plate 1 is limited between the second connecting part 32 of the connecting piece 3 and the extension part 22 of the outer frame 2. In a thickness direction Z of the middle plate 1 and a direction X parallel to the middle plate 1, it is not easy to generate relative displacement between the middle plate 1 and the connecting piece 3, and it is not easy to separate the middle plate 1 from the connecting piece 3. In addition, both the first connecting part 31 and the second connecting part 32 of the connecting piece 3 are in contact with the middle plate 1, and a contact area between the middle plate 1 and the connecting piece 3 may be further increased. A connection between the middle plate 1, the outer frame 2, and the connecting piece 3 may be stable, thereby helping further improve a yield rate of the middle frame 20 and improve use stability of the middle frame 20.

It may be understood that, as shown in FIG. 7A, when the mounting hole 11 is the blind hole, and the blind hole is located on the side that is of the middle plate 1 and that is away from the extension part 22, the connecting piece 3 is not only welded to the outer frame 2, but also welded to the middle plate 1. However, in comparison with a solution in which the middle plate 1 and the outer frame 2 are directly welded, a thickness of the middle plate 1 between the first connecting part 31 and the outer frame 2 is small, the material of the middle plate 1 at a welding joint between the first connecting part 31 and the outer frame 2 is less, and the material of the middle plate 1 has small impact on performance of a welding point formed between the first connecting part 31 and the extension part 22. This can resolve a problem that when the middle plate and the outer frame are directly welded, a welding defect occurs at a welding joint between the middle plate and the outer frame because the magnesium alloy or the magnesium matrix composite material has a low melting point, tends to evaporate, has high activity, and is susceptible to oxidation, or because there are a large quantity of air holes in a die casting aluminum material, so that reliability of a connection between the middle plate 1 and the outer frame 2 may be high. This helps improve stability of the middle frame 20, and improve an impact resistance capability of the middle frame 20, and ensures consistency of radio frequency performance of a frame antenna in the electronic device 100.

In some examples, as shown in FIG. 5, the first connecting part 31 is located in the mounting hole 11, and the second connecting part 32 may be located outside the mounting hole 11. In this case, an end face 321 that is of the second connecting part 32 and that is connected to the first connecting part 31 may be in contact with a surface S1 that is of the middle plate 1 and that is away from the extension part 22.

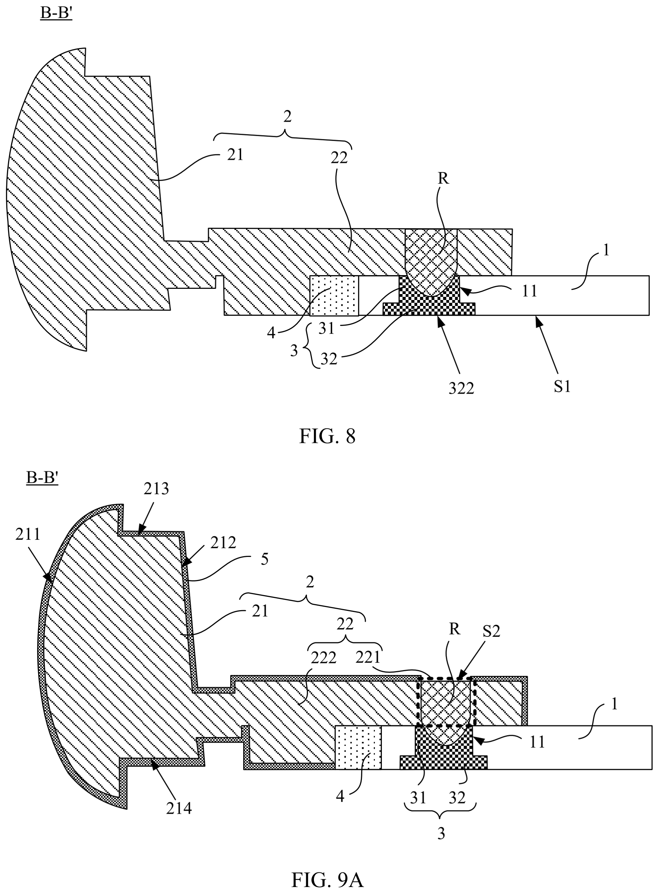

FIG. 8 is another sectional view of the middle frame 20 shown in FIG. 3 at B-B'. Refer to FIG. 8, in some other examples, the mounting hole 11 is a stepped hole, and both the first connecting part 31 and the second connecting part 32 are located in the stepped hole. In this case, an end face 322 that is of the second connecting part 32 and that is away from the first connecting part 31 is flush with the surface S1 that is of the middle plate 1 and that is away from the extension part 22. In this way, flatness of the middle frame 20 can be high, so that the middle frame 20 can better carry an electronic component or a display, and a yield rate of the electronic device 100 using the middle frame 20 can be improved.

In some examples, the connecting piece 3 may be a flat-headed rivet. A rivet head of the flat-headed rivet corresponds to the second connecting part 32, and a rivet rod of the flat-headed rivet corresponds to the first connecting part 31. When the connecting piece 3 is the flat-headed rivet, an end face that is of the second connecting part 32 and that is away from the first connecting part 31 is a plane. This helps improve surface flatness of the middle plate 1 on which the connecting piece 3 is mounted.

Still refer to FIG. 7B. In some other embodiments, the connecting piece 3 is a cylinder, and the connecting piece 3 is in interference fit with the mounting hole 11. In this way, a structure of the connecting piece 3 is simple and easy to obtain. This helps simplify a structure of the middle frame 20.

It may be understood that, to improve flatness of the middle frame 20, when the connecting piece 3 is the cylinder, a surface of the connecting piece 3 may be flush with a surface that is of the middle plate 1 and that is close to the extension part 22 or a surface that is of the middle plate 1 and that is away from the extension part 22.

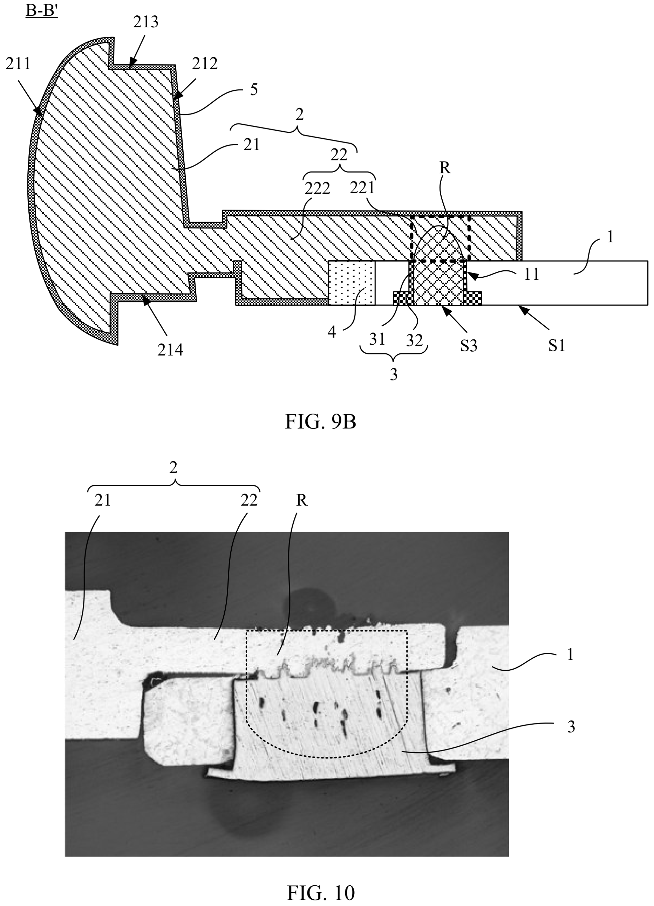

In some embodiments, as shown in FIG. 9A and FIG. 9B, the extension part 22 includes a first part 221 and a second part 222, the second part 222 is disposed around the first part 221, and the first part 221 and the connecting piece 3 have a molten pool R. A depth and a width of the molten pool R are not limited in this embodiment of this application, and may be designed based on an actual requirement.

FIG. 10 is a physical diagram of the middle frame 20 at the welding joint between the extension part 22 and the connecting piece 3 according to an embodiment of this application. A material of the extension part 22 is aluminum alloy, and a material of the connecting piece 3 is titanium. In this case, as shown in FIG. 10, because a diffusion capability of the material (titanium) of the connecting piece 3 is greater than a diffusion capability of the material (aluminum alloy) of the extension part 22, the material of the connecting piece 3 extends from an interface at which the connecting piece 3 is in contact with the extension part 22 to the extension part 22.

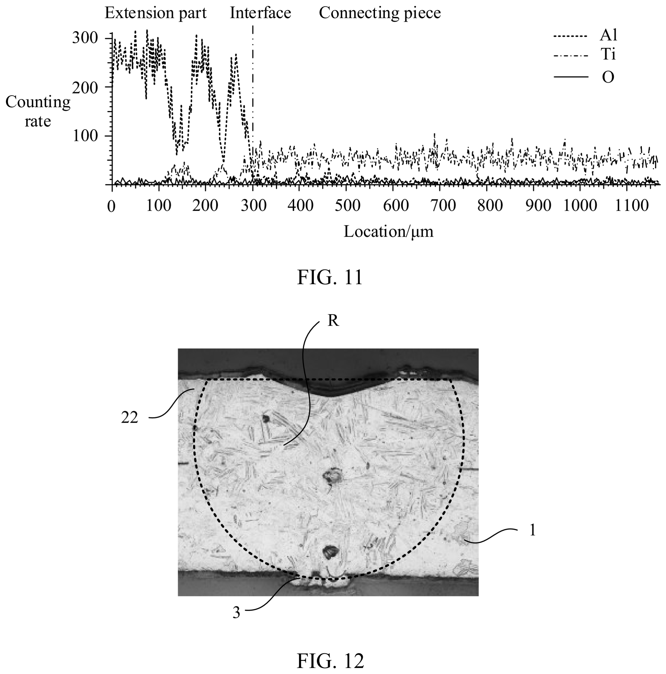

FIG. 11 is a diagram of an element detection result of the middle frame 20 at the welding joint between the extension part 22 and the connecting piece 3 according to an embodiment of this application. As shown in FIG. 11, in the molten pool R, an element (Al) of the outer frame 2 may pass through an interface between the extension part 22 and the connecting piece 3, and diffuse into the connecting piece 3. An element (Ti) of the connecting piece 3 may pass through the interface between the extension part 22 and the connecting piece 3, and diffuse into the extension part 22.

FIG. 12 is another physical diagram of the extension part 22 at the welding joint between the outer frame 2 and the connecting piece 3 according to an embodiment of this application. A material of the extension part 22 is the same as a material of the connecting piece 3, and both are titanium. As shown in FIG. 12, in the molten pool R, the material of the extension part 22 and the material of the connecting piece 3 are remelted after welding, and obvious crystal bonds are formed between atoms.

In some examples, as shown in FIG. 9A, the molten pool R may extend from a surface S2 that is of the first part 221 and that is away from the middle plate 1 to the connecting piece 3.

In some other examples, as shown in FIG. 9B, the molten pool R may extend from a surface S3 that is of the connecting piece 3 and that is away from the extension part 22 to the first part 221.

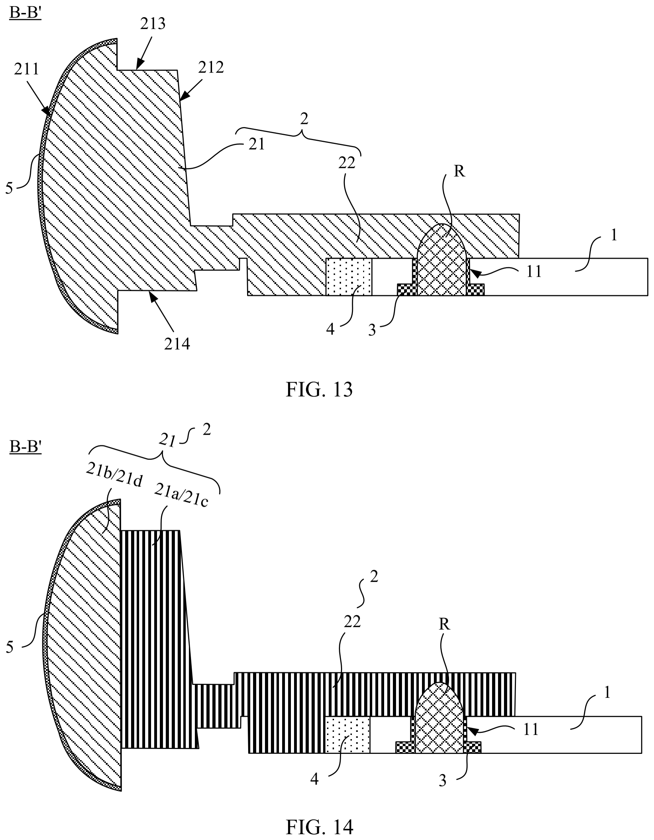

In some embodiments, refer to FIG. 9A, FIG. 9B, and FIG. 13. The main body part 21 includes a first surface 211 and a second surface 212 that are opposite to each other, and a first side surface 213 and a second side surface 214 that are connected to the first surface 211 and the second surface 212. The first surface 211 is farther away from the extension part 22 than the second surface 212, and the second surface 212 is connected to the extension part 22.

For example, as shown in FIG. 9A, FIG. 9B, and FIG. 13, the first surface 211 may be a curved surface. In this way, different positions of the first surface 211 may have same mechanical strength. In comparison with a solution in which the first surface 211 is a plane, the first surface 211 is the curved surface, so that the outer frame 2 can be made of fewer materials, thereby helping reduce a weight of the outer frame 2. In addition, the first surface 211 is the curved surface, so that the surface of the outer frame 2 can be smooth, thereby avoiding a case in which the outer frame scratches another structure of the electronic device or a user, and improving user experience of the electronic device 100 using the middle frame 20.

In some embodiments, as shown in FIG. 9A, FIG. 9B, and FIG. 13, the middle frame 20 further includes a decorative layer 5, and the decorative layer 5 covers at least the first surface 211.

When the material of the outer frame 2 includes aluminum alloy, the decorative layer 5 may be formed by using an anodic oxidation process. In this case, the material of the decorative layer 5 may include aluminum oxide. When the material of the outer frame 2 includes one of a titanium-based material, an iron-based material, a titanium-aluminum composite material, and a steel-aluminum composite material, the decorative layer 5 may be formed by using a physical vapor deposition process. In this case, the material of the decorative layer 5 may include titanium nitride, or another film layer containing nitrogen or carbon. A thickness of the decorative layer 5 is not limited in this embodiment of this application, provided that the decorative layer 5 can protect the outer frame 2.

In this embodiment of this application, the decorative layer 5 is disposed, so that a surface of the outer frame 2 can be colored, appearance effect of the outer frame 2 can be improved, and a user's preference for the electronic device 100 can be increased. In addition, the decorative layer 5 can be used to protect the outer frame 2, to avoid erosion of the outer frame 2 by water vapor and oxygen in an environment.

In some examples, as shown in FIG. 9A, the molten pool R extends from the surface S2 that is of the first part 221 and that is away from the middle plate 1 to the connecting piece 3. In this case, in addition to the first surface 211, the decorative layer 5 may further cover a surface that is of the second part 222 and that is away from the middle plate 1, the first side surface 213, the second side surface 214, and a part that is of the second surface 212 and that is not in contact with the extension part 22. That is, the decorative layer 5 covers the surface of the main body part 21 and the surface that is of the second part 222 of the extension part 22 and that is away from the middle plate 1.

In the middle frame 20 provided in this embodiment of this application, in addition to the first surface 211, the decorative layer 5 further covers the surface that is of the second part 222 and that is away from the middle plate 1, the first side surface 213, the second side surface 214, and the part that is of the second surface 212 and that is not in contact with the extension part 22. The decorative layer 5 can be used to protect the second part 222 of the extension part 22 and the main body part 21, so that the second part 22 and the main body part 21 are not easily eroded by water vapor and oxygen in an external environment. In addition, the decorative layer 5 can be used to improve appearance effect of the second part 222 and the main body part 21, so that the second part 222 and the main body part 21 can have rich colors. Therefore, the middle frame 20 provided in this embodiment of this application can have good appearance effect, and appearance effect of the electronic device 100 using the middle frame 20 can be improved.

When the molten pool R extends from the surface S2 that is of the first part 221 and that is away from the middle plate 1 to the connecting piece 3, the decorative layer 5 exposes the surface that is of the first part 221 and that is away from the connecting piece 3 and the surface that is of the first part 221 and that is close to the connecting piece 3. This helps avoid affecting a welding yield rate due to a high melting point of the decorative layer 5.

In some other examples, as shown in FIG. 9B, the molten pool R extends from the surface that is of the connecting piece 3 and that is away from the extension part 22 to the first part 221. In this case, in addition to the first surface 211, the decorative layer 5 further covers the surface that is of the first part 221 and that is away from the middle plate 1, the surface that is of the second part 222 and that is away from the middle plate 1, the first side surface 213, the second side surface 214, and the part that is of the second surface 212 and that is not in contact with the extension part 22. In other words, the decorative layer 5 covers a remaining surface of the outer frame 2 other than the surface that is of the first part 221 and that is close to the connecting piece 3 and the surface that is of the second part 222 and that is close to the middle plate 1.

In this embodiment of this application, in addition to the first surface 211, the decorative layer 5 further covers the surface that is of the first part 221 and that is away from the middle plate 1, the surface that is of the second part 222 and that is away from the middle plate 1, the first side surface 213, the second side surface 214, and the part that is of the second surface 212 and that is not in contact with the extension part 22. The decorative layer 5 can be used to protect the extension part 22 and the main body part 21, so that the extension part 22 and the main body part 21 are not easily eroded by water vapor and oxygen in an external environment. In addition, the decorative layer 5 can be used to improve appearance effect of the main body part 21 and the extension part 22, so that the main body part 21 and the extension part 22 can have rich colors. Therefore, the middle frame 20 provided in this embodiment of this application can have good appearance effect, and appearance effect of the electronic device 100 using the middle frame 20 can be improved.

When the molten pool R extends from the surface that is of the connecting piece 3 and that is away from the extension part 22 to the first part 221, the decorative layer 5 exposes the surface that is of the first part 221 and that is close to the connecting piece 3. This helps avoid affecting the welding yield rate due to the high melting point of the decorative layer 5.

In some other examples, as shown in FIG. 13 and FIG. 14, the decorative layer 5 may cover only the first surface 211. In this way, in a process of welding the connecting piece 3 and the extension part 22, the decorative layer 5 is not likely to cause adverse impact on the welding joint between the extension part 22 and the connecting piece 3. In addition, in this way, the coverage area of the decorative layer 5 is small, so that the appearance effect of the main body part 21 and the middle frame 20 can be improved, and preparation costs of the middle frame 20 can be reduced.

In some examples, as shown in FIG. 14, the material of the outer frame 2 includes a titanium-aluminum composite material, the main body part 21 includes a first sublayer 21a and a second sublayer 21b, the first sublayer 21a is farther away from the extension part 22 than the second sublayer 21b, the second sublayer 21b is connected to the extension part 21, a material of the first sublayer 21a includes titanium, and materials of the second sublayer 21b and the extension part 22 both include aluminum alloy.

In the outer frame 2 provided in this embodiment of this application, the material of the first sublayer 21a of the main body part 21 is set to titanium metal, the material of the second sublayer 21b is set to aluminum alloy, and the material of the extension part 22 is set to aluminum alloy. A density of the aluminum alloy is less than a density of the titanium metal, so that the middle frame 20 can have a small weight while having a metal texture and appearance effect, thereby helping reduce preparation costs of the middle frame 20.

In some other examples, still refer to FIG. 14. The material of the outer frame 2 includes a steel-aluminum composite material, the main body part 21 includes a third sublayer 21c and a fourth sublayer 21d, the third sublayer 21c is farther away from the extension part 22 than the fourth sublayer 21d, the fourth sublayer 21d is connected to the extension part 22, a material of the third sublayer 21c includes stainless steel, and materials of the fourth sublayer 21d and the extension part 22 both include aluminum alloy.

In the outer frame 2 provided in this embodiment of this application, the material of the first sublayer 21a of the main body part 21 is set to stainless steel, the material of the second sublayer 21b is set to aluminum alloy, and the material of the extension part 22 is set to aluminum alloy. A density of the aluminum alloy is less than a density of the stainless steel, so that the middle frame 20 can have a small weight while having a metal texture and appearance effect, thereby helping reduce preparation costs of the middle frame 20.

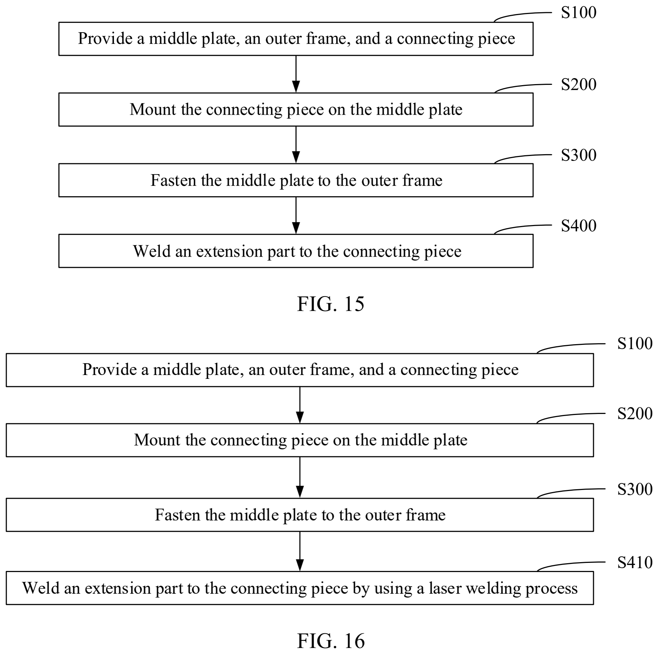

As shown in FIG. 15, an embodiment of this application provides a middle frame preparation method. The preparation method includes step S100 to step S400.

S100: Refer to FIG. 2 and FIG. 5, provide a middle plate 1, an outer frame 2, and a connecting piece 3. The outer frame 2 includes a main body part 21 and an extension part 22 that are connected to each other, and a thickness of the extension part 22 is less than a thickness of the main body part 21.

For example, the middle plate 1 may be prepared by using a die casting process or a semi-solid die casting process. In this case, a material of the middle plate may include but is not limited to die casting magnesium alloy AZ91D, AM6, and the like. Alternatively, the middle plate 1 may be obtained in a punching or cutting manner. In this case, a material of the middle plate 1 may include but is not limited to AZ31, AZ80, AZ91D, ZK61, a magnesium matrix composite material, and the like.

In some examples, a material of the outer frame 2 includes aluminum alloy. In this case, the outer frame 2 may be obtained by using a punching process or CNC processing.

In some other examples, a material of the outer frame 2 includes a titanium-based material, an iron-based material, a titanium-aluminum composite material, and a steel-aluminum composite material. In this case, if a raw material of the outer frame is in a strip shape, the raw material may be processed in a bending and forging manner to obtain the outer frame 2. If the raw material of the outer frame is in a plate shape, the outer frame 2 may be obtained in a punching and cutting manner.

S200: Mount the connecting piece 3 on the middle plate 1. The connecting piece 3 is located in a mounting hole 11 of the middle plate 1.

In some examples, the mounting hole 11 may be formed in a process of preparing the middle plate 1. In some other examples, the mounting hole 11 may be formed in a process of mounting the connecting piece 3 on the middle plate 1. This is not limited in this application.

In some examples, after the connecting piece 3 is mounted on the middle plate 1, the middle plate 1 and the connecting piece 3 may be passivated, to form an oxidized layer on the middle plate 1 and the connecting piece 3, and protect the middle plate 1 and the connecting piece 3.

S300: Fasten the middle plate 1 to the outer frame 2. The outer frame 2 is located on an outer side of the middle plate 1, the extension part 22 is located on a side that is of the main body part 21 and that faces the middle plate 1, and the extension part 22 and the middle plate 1 are stacked. For example, the middle plate 1 may be fastened to the outer frame 2 by using a clamping fixture.

S400: Weld the extension part 22 to the connecting piece 3.

A material of the middle plate 1 includes one of magnesium alloy, a magnesium matrix composite material, and aluminum alloy, and a material of the outer frame 2 includes one of aluminum alloy, a titanium-based material, an iron-based material, a titanium-aluminum composite material, and a steel-aluminum composite material. Microhardness of the connecting piece 3 is greater than microhardness of the middle plate 1.

The beneficial effect that can be achieved by the preparation method provided in this embodiment of this application are the same as the technical effect that can be achieved by the middle frame 20 provided in the foregoing embodiment of this application. Details are not described herein again in this application.

In some embodiments, as shown in FIG. 16, step S400 may include step S410.

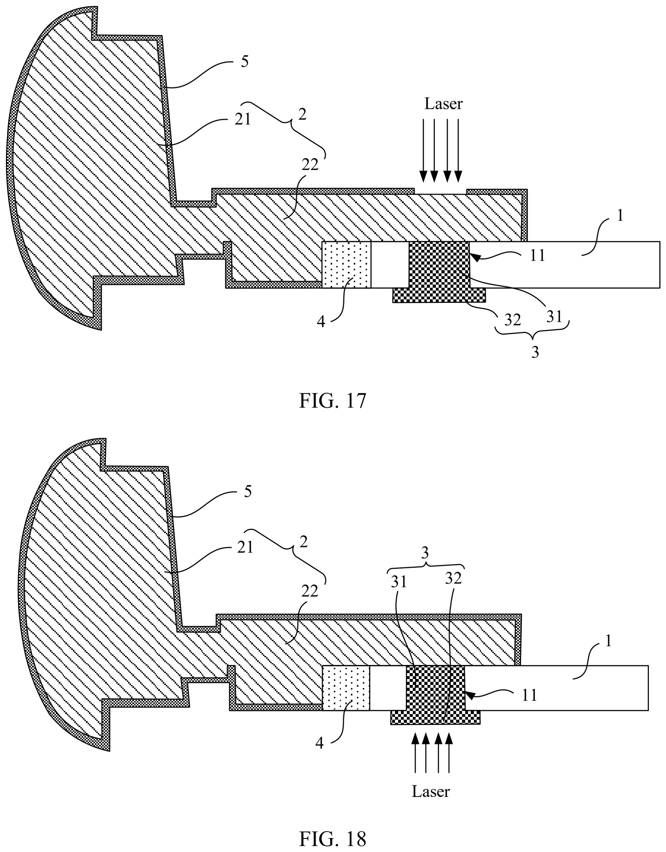

S410: As shown in FIG. 17 and FIG. 18, weld the extension part 22 to the connecting piece 3 by using a laser welding process.

In this case, in some examples, as shown in FIG. 17, a laser may be irradiated from a side that is of the extension part 22 and that is away from the connecting piece 3 to the connecting piece 3. In some other examples, as shown in FIG. 18, the laser may be irradiated from a side that is of the connecting piece 3 and that is away from the extension part 22 to the extension part 22.

Parameters such as laser welding time and laser intensity are not limited in this embodiment of this application, and may be designed based on an actual requirement.

In this embodiment of this application, the extension part 22 and the connecting piece 3 are welded by using a laser welding process, so that welding precision may be high, a deformation amount of the extension part 22 and the connecting piece 3 may be small, and stress between the extension part 22 and the connecting piece 3 may be small. After the extension part 22 and the connecting piece 3 are welded, the middle frame 20 is not easily deformed, thereby helping improve flatness of the middle frame 20. In addition, laser welding has a high welding speed. The extension part 22 and the connecting piece 3 are welded by using the laser welding process, which is conducive to improving a preparation speed of the middle frame 20 and improving preparation efficiency of the middle frame 20.

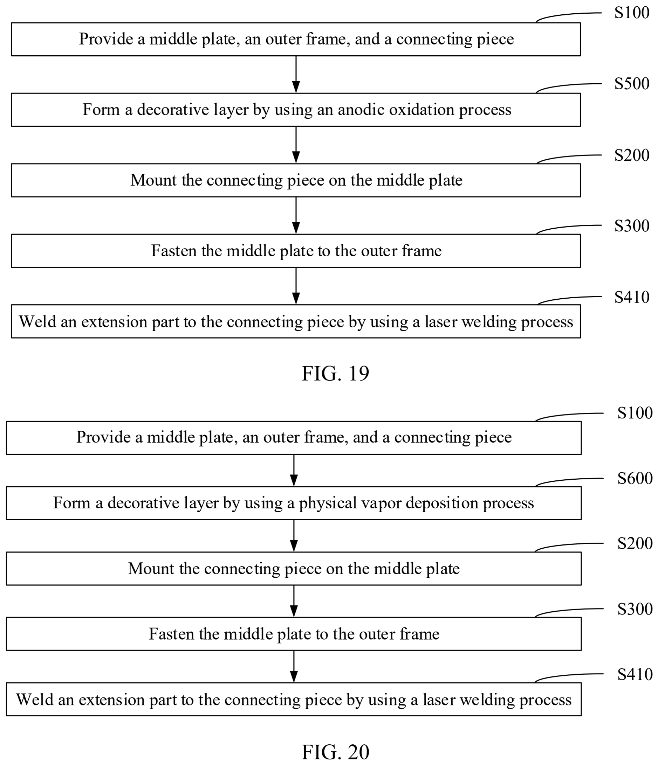

In some embodiments, a material of the outer frame 2 includes aluminum alloy. In this case, as shown in FIG. 19, the preparation method further includes step S500.

S500: Form a decorative layer 5 by using an anodic oxidation process.

In some other embodiments, a material of the outer frame 2 includes one of a titanium-based material, an iron-based material, a titanium-aluminum composite material, and a steel-aluminum composite material. In this case, as shown in FIG. 20, the preparation method further includes step S600.

S600: Form a decorative layer 5 by using a physical vapor deposition process.

As shown in FIG. 13, the main body part 21 includes a first surface 211 and a second surface 212 that are opposite to each other, and a first side surface 213 and a second side surface 214 that are connected to the first surface 211 and the second surface 212. The first surface 211 is farther away from the middle plate 1 than the second surface 212, and the second surface 212 is connected to the extension part 22. The decorative layer 5 covers at least the first surface 211. As shown in FIG. 19 and FIG. 20, the decorative layer 5 may be formed before step S400.

In some examples, before the decorative layer 5 is formed, the outer frame 2 may be further ground and polished. The grinding and polishing processing can reduce surface roughness of the outer frame 2, and prevent the outer frame 2 from being too rough and affecting another structure of the electronic device.

In this embodiment of this application, the decorative layer 5 is disposed, so that a surface of the outer frame 2 can be colored, appearance effect of the outer frame 2 can be improved, and a user's preference for the electronic device 100 can be increased. In addition, the decorative layer 5 can be used to protect the outer frame 2, to avoid erosion of the outer frame 2 by water vapor and oxygen in an environment.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A middle frame, comprising:
a middle plate (1), comprising a mounting hole (11);
an outer frame (2), located on an outer side of the middle plate (1), wherein the outer frame (2) comprises a main body part (21) and an extension part (22) that are connected to each other, the extension part (22) is located on a side that is of the main body part (21) and that faces the middle plate (1), a thickness of the extension part (22) is less than a thickness of the main body part (21), and the extension part (22) and the middle plate (1) are stacked; and
a connecting piece (3), located in the mounting hole (11) and connected to the middle plate (1), wherein the connecting piece (3) is welded to the extension part (22); and
a material of the middle plate (1) comprises one of magnesium alloy, a magnesium matrix composite material, and aluminum alloy, a material of the outer frame (2) comprises one of aluminum alloy, a titanium-based material, an iron-based material, a titanium-aluminum composite material, and a steel-aluminum composite material, and microhardness of the connecting piece (3) is greater than microhardness of the middle plate (1).

2. The middle frame according to claim 1, wherein the connecting piece (3) comprises a first connecting part (31) and a second connecting part (32) that are perpendicular to each other, the first connecting part (31) is located in the mounting hole (11), and is welded to the extension part (22), and a part of the middle plate (1) is located between the second connecting part (32) and the extension part (22).

3. The middle frame according to claim 2, wherein the mounting hole (11) is a stepped hole, both the first connecting part (31) and the second connecting part (32) are located in the stepped hole, and an end face that is of the second connecting part (32) and that is away from the first connecting part (31) is flush with a surface that is of the middle plate (1) and that is away from the extension part (22).

4. The middle frame according to claim 1, wherein the connecting piece (3) is a cylinder, and the connecting piece (3) is in interference fit with the mounting hole (11).

5. The middle frame according to any one of claims 1 to 4, wherein a material of the connecting piece (3) is the same as the material of the outer frame (2).

6. The middle frame according to any one of claims 1 to 5, wherein the mounting hole (11) comprises a through hole or a blind hole.

7. The middle frame according to any one of claims 1 to 6, wherein the extension part (22) comprises a first part (221) and a second part (222), the second part (222) is disposed around the first part (221), the first part (221) and the connecting piece (3) have a molten pool (R), and the molten pool (R) extends from a surface that is of the first part (221) and that is away from the middle plate (1) to the connecting piece (3), or the molten pool (R) extends from a surface that is of the connecting piece (3) and that is away from the extension part (22) to the first part (221).

8. The middle frame according to any one of claims 1 to 7, wherein the main body part (21) comprises a first surface (211) and a second surface (212) that are opposite to each other, and a first side surface (213) and a second side surface (214) that are connected to the first surface (211) and the second surface (212), the first surface (211) is farther away from the extension part (22) than the second surface (212), and the second surface (212) is connected to the extension part (22); and
the middle frame (20) further comprises a decorative layer (5), and the decorative layer (5) covers at least the first surface (211).

9. The middle frame according to claim 8, wherein the molten pool (R) extends from the surface that is of the first part (221) and that is away from the middle plate (1) to the connecting piece (3), and the decorative layer (5) further covers a surface that is of the second part (222) and that is away from the middle plate (1), the first side surface (213), the second side surface (214), and a part that is of the second surface (212) and that is not in contact with the extension part (22).

10. The middle frame according to claim 8, wherein the molten pool (R) extends from the surface that is of the connecting piece (3) and that is away from the extension part (22) to the first part (221), and the decorative layer (5) further covers the surface that is of the first part (221) and that is away from the middle plate (1), a surface that is of the second part (222) and that is away from the middle plate (1), the first side surface, the second side surface, and a part that is of the second surface (212) and that is not in contact with the extension part (22).

11. The middle frame according to any one of claims 1 to 10, wherein shear strength at a welding joint between the extension part (22) and the connecting piece (3) is greater than or equal to 100 N, and pulling strength at the welding joint between the extension part (22) and the connecting piece (3) is greater than or equal to 90 N.

12. The middle frame according to any one of claims 1 to 11, wherein the material of the outer frame (2) comprises the titanium-aluminum composite material, the main body part (21) comprises a first sublayer (21a) and a second sublayer (21b), the first sublayer (21a) is farther away from the extension part (22) than the second sublayer (21b), the second sublayer (21b) is connected to the extension part (22), a material of the first sublayer (21a) comprises titanium, and materials of the second sublayer (21b) and the extension part (22) both comprise aluminum alloy; or
the material of the outer frame (2) comprises the steel-aluminum composite material, the main body part (21) comprises a third sublayer (21c) and a fourth sublayer (21d), the third sublayer (21c) is farther away from the extension part (22) than the fourth sublayer (21d), the fourth sublayer (21d) is connected to the extension part (22), a material of the third sublayer (21c) comprises stainless steel, and materials of the fourth sublayer (21d) and the extension part (22) both comprise aluminum alloy.

13. A middle frame preparation method, comprising:
providing a middle plate (1), an outer frame (2), and a connecting piece (3), wherein the outer frame (2) comprises a main body part (21) and an extension part (22) that are connected to each other, and a thickness of the extension part (22) is less than a thickness of the main body part (21);
mounting the connecting piece (3) on the middle plate (1), wherein the connecting piece (3) is located in a mounting hole (11) of the middle plate (1);
fastening the middle plate (1) to the outer frame (2), wherein the outer frame (2) is located on an outer side of the middle plate (1), the extension part (22) is located on a side that is of the main body part (21) and that faces the middle plate (1), and the extension part (22) and the middle plate (1) are stacked; and
welding the extension part (22) to the connecting piece (3), wherein
a material of the middle plate (1) comprises one of magnesium alloy, a magnesium matrix composite material, and aluminum alloy, a material of the outer frame (2) comprises one of aluminum alloy, a titanium-based material, an iron-based material, a titanium-aluminum composite material, and a steel-aluminum composite material, and microhardness of the connecting piece (3) is greater than microhardness of the middle plate (1).

14. The preparation method according to claim 13, wherein welding the extension part (22) to the connecting piece (3) comprises: welding the extension part (22) to the connecting piece (3) by using a laser welding process.

15. The preparation method according to claim 13 or 14, wherein
the material of the outer frame (2) comprises the aluminum alloy, and the preparation method further comprises: forming a decorative layer (5) by using an anodic oxidation process; or
the material of the outer frame (2) comprises one of the titanium-based material, the iron-based material, the titanium-aluminum composite material, and the steel-aluminum composite material, and the preparation method further comprises: forming a decorative layer (5) by using a physical vapor deposition process, wherein
the main body part (21) comprises a first surface (211) and a second surface (212) that are opposite to each other, and a first side surface and a second side surface that are connected to the first surface and the second surface, the first surface (211) is farther away from the middle plate (1) than the second surface (212), the second surface (212) is connected to the extension part (22), and the decorative layer (5) covers at least the first surface (211).

16. An electronic device, comprising:
a display (10) and a rear housing (30); and
the middle frame (20) according to any one of claims 1 to 12, wherein the middle frame (20) is located between the display (10) and the rear housing (30), and an outer frame (2) of the middle frame (20) is used as a side edge of the electronic device (100).
